# EUROPEAN PATENT APPLICATION

(11) **EP 0 631 302 A2**
(43) Date of publication of application: **28.12.1994**
(21) Application number: 94109010.2
(22) Date of filing: 13.06.1994
(51) Int. Cl.: H01L 21/336, H01L 29/784, H01L 29/10

(54) **Method of manufacturing a p-channel MOSFET**

(30) Priority: 22.06.1993 US 79576
(71) Applicant: MOTOROLA, INC., Schaumburg, IL 60196 (US)
(72) Inventor: Masquelier, Michael P., Phoenix, Arizona 85016 (US); Davies, Robert B., Tempe, Arizona 85281 (US)
(74) Representative: Hudson, Peter David

(57) **Abstract**

A method for controlling carrier concentration at the interface of oppositely doped regions of a semiconductor device is provided. According to a preferred method, the threshold voltage of a graded channel field effect device is thereby controlled. Preferably, spacers (80,82) are provided adjacent a gate electrode (56) to offset the location of the extent (88,90) of source/drain regions (84,86) within graded channel regions (60,62). The extent (88,90) of the source/drain regions (84,86) are thereby located at a desired point of the carrier concentration profile of the graded channel regions (60,62).

## Description

### Background of the Invention

The present invention relates to semiconductor devices, and more particularly, to controlling the carrier concentrations of doped regions at their interfaces.

It is often desirable to control the carrier concentration profiles of various doped regions of a semiconductor device, with respect to one another. For example, double diffused metal oxide semiconductor (DMOS) devices present a particular problem which requires controlling the carrier concentration profile of various doped regions with respect to one another.

The well-known techniques for fabricating DMOS devices have been found very useful in the past for a variety of reasons. For example, in the case of field effect devices, diffused channel and source/drain regions result in self-alignment of the respective active regions. The self-alignment provides simplified processing and more dense device packing. Additionally, diffusing channel regions under the gate results in varying carrier concentrations across the length of the gate. This is known as a graded channel, and provides advantages such as higher carrier mobility, and consequently better device performance.

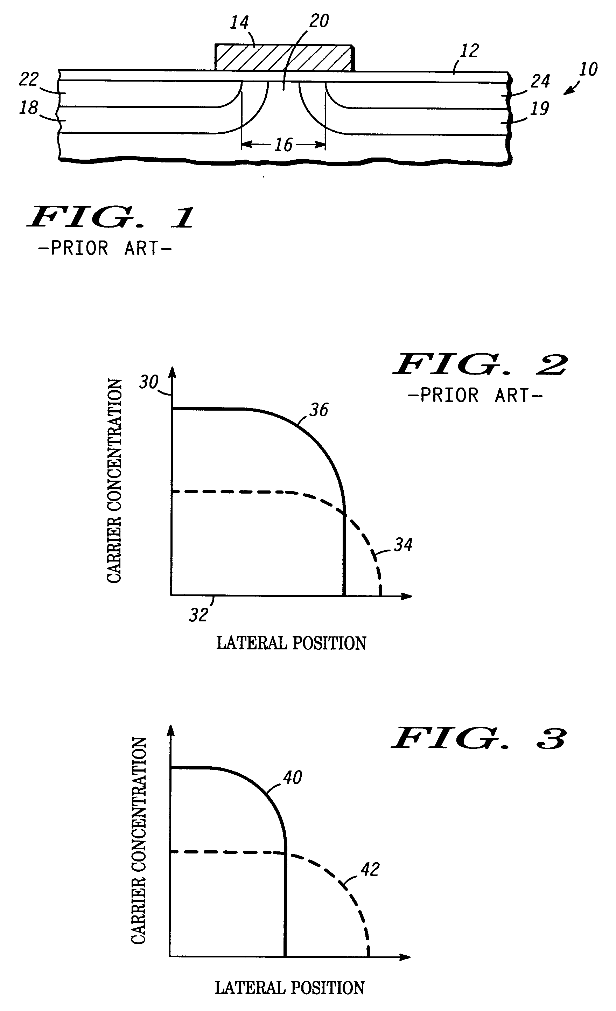

FIG. 1 is a schematic cross-section view of a DMOS field effect device of the prior art. FIG. 1 shows one of many substantially identical devices which may be found on a chip (die). Semiconductor substrate 10 is provided. Oxide insulating layer 12 lies on top of the substrate. Gate electrode 14 lies on top of the insulating layer 12. Channel region 16 comprises the diffused graded channel portions 18 and 19 and a well portion 20. Graded channel regions 18 and 19 have been implanted and diffused both vertically and laterally beneath gate electrode 14, resulting in respective graded carrier concentration profiles, described in more detail below.

The prior art device further comprises source/drain region 22 and source/drain region 24. Source/drain regions 22 and 24 are also implanted and diffused beneath gate electrode 14, as is well known in the art. The resultant DMOS field effect device provides the above discussed advantages associated with the self-aligned process. However, the DMOS field effect device of the prior art presents a particular disadvantage with regard to controlling the threshold voltage of the device.

The threshold voltage (Vₜₕ) relates to the voltage at which a device turns on. It is highly desirable to control the Vₜₕ so that it's value is consistent for any particular product. Vₜₕ affects critical performance parameters such as power consumption and switching speed.

In a device such as the one illustrated by FIG. 1, the Vₜₕ is strongly related to the carrier concentration of the channel region at the location where the channel region meets the source/drain region. FIG. 2 represents carrier concentration profile as a function of lateral position across the device. Carrier concentration increases along axis 30 while lateral position is reflected by axis 32. Dashed curve 34 represents the carrier concentration profile of a graded channel region such as the region 18 of FIG. 1. Solid curve 36 represents the carrier concentration profile of the diffused source/drain region 22 of FIG. 1. The intersection of the curves 34 and 36 represents the peak channel carrier concentration referred to above. The carrier concentration at this intersection strongly effects Vₜₕ.

The graph of FIG. 2 illustrates that the diffused source/drain region profile meets the graded channel profile at a point where the carrier concentration of the graded channel is varying rapidly. This is seen as the relatively steep slope portion of curve 34 which is intersected by curve 36. Consequently, even a small variation in the placement of source/drain region 22 will have a substantial effect on the Vₜₕ. Therefore, the DMOS technology of the prior art is inherently susceptible to variations in Vₜₕ.

In the past, DMOS has been applied primarily to power devices where Vₜₕ is relatively very high. Consequently, smaller variations in Vₜₕ are tolerable. However, presently, DMOS techniques are being applied to low power digital devices, wherein controllability of Vₜₕ is very important.

The case of DMOS, as discussed above, emphasizes that it is highly desirable to control the carrier concentration at the interface of oppositely doped regions of a semiconductor device.

### Summary of the Invention

Briefly stated, the scope of the present invention encompasses a method for controlling carrier concentration at the interface of oppositely doped regions of a semiconductor device. A semiconductor substrate is provided. An electrode is formed on a surface of the semiconductor substrate. A first doped region which has a first dopant type is formed in the semiconductor substrate. The first doped region has a first carrier concentration profile. This doped region is aligned by an edge of the electrode. A spacer is formed adjacent the electrode. Additionally, a second doped region having a second dopant type which is opposite the first dopant type is formed in the semiconductor substrate. The second doped region is aligned by the spacer. The second doped region extends in the lateral direction under the electrode. The extent is determined by the spacer. The second doped region meets the first doped region at the extent of the second doped region. The extent is located where the first carrier concentration profile is substantially flat.

### Brief Description of the Drawings

FIG. 1 is a schematic cross-section of a portion of a DMOS field effect device of the prior art;
FIG. 2 is a graphical representation of the carrier concentration profile of doped regions of the device of FIG. 1;
FIG. 3 is a graphical illustration of the carrier concentration profile of doped regions provided by a method in accordance with the present invention;
FIG. 4 is a schematic cross-section illustrating a stage in the formation of a device made in accordance with the present invention, just after a gate electrode is formed;
FIG. 5 shows the structure of FIG. 4, just after the drive of graded channel regions;
FIG. 6 shows the structure of FIG. 5, just after a nitride layer is formed; and
FIG. 7 shows the structure of FIG. 6 after spacers are formed and source/drain regions are formed.

### Detailed Description of the Drawings

FIG. 1 is a schematic cross-section of a DMOS field effect device of the prior art, as detailed in the Background section of the present application. FIG. 2 is a graphical representation of the carrier concentration profile of a source/drain region and a graded channel region of the prior art device, as a function of lateral position across the device. These figures are presented here for comparison, in particular with respect to FIG. 3.

FIG. 3 graphically represents the carrier concentration profiles of a source/drain region and a graded channel region of a device made in accordance with the present invention, as a function of lateral placement across the semiconductor substrate. The curve 40 represents the profile of a source/drain region analogous to curve 36 of FIG. 1. Curve 42 represents the profile of a graded channel region analogous to curve 34 of FIG. 1. According to a preferred method of the present invention curve 40 is pushed back so as to intersect curve 42 along a flatter portion of the profile of the graded channel region. Consequently, slight variations in the placement of either region due to processing variations will have relatively little effect on Vₜₕ. A preferred method within the scope of the present invention provides a novel and non-obvious way of achieving the profile illustrated by FIG. 3.

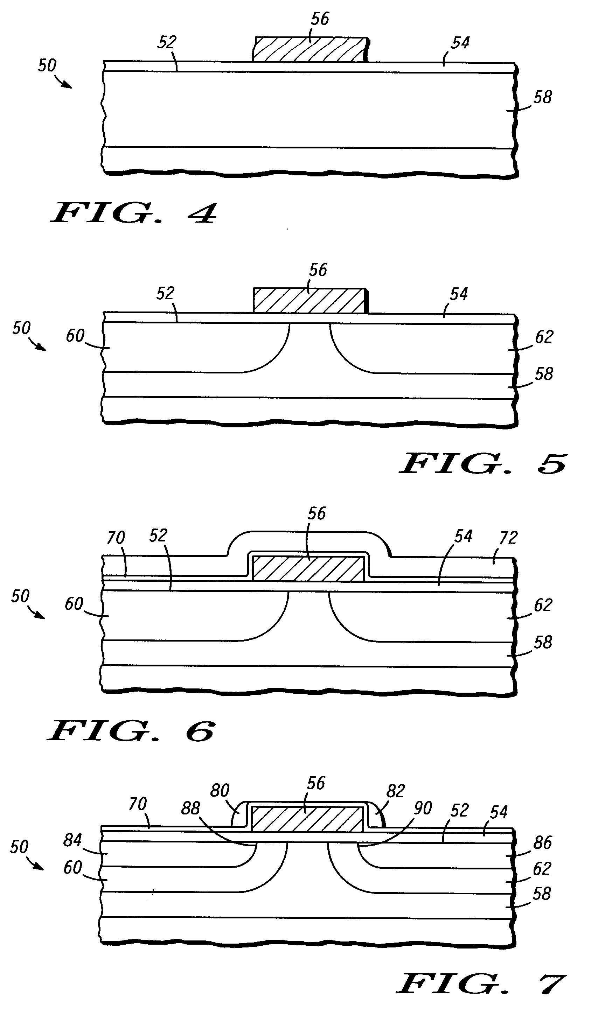

A device made in accordance with the preferred method is a DMOS field effect device. FIGs. 4-7 illustrate various stages in the formation of the preferred DMOS field effect device. FIGs. 4-7 show one of many substantially identical devices which may be found on a chip (die). The preferred device is a p-channel enhancement mode field effect device, having p-type source/drain regions and n-type graded channel and channel well regions. However, it will be readily recognized by those skilled in the art that substitutions of dopant types, materials and processes may be made to the following described method and device while remaining within the scope of the present invention.

In FIG. 4, semiconductor substrate 50 is provided. In the preferred embodiment, semiconductor substrate 50 is lightly doped with boron to provide a p- conductivity. The semiconductor substrate has a surface 52. A well region 58 is formed beneath surface 52, preferably by implanting phosphorous into substrate 50. Insulating layer 54 is formed on surface 52. Insulating layer 54 may comprise insulating oxide and may be formed with well known processing techniques such as thermal oxide growth. Electrode 56 is formed above insulating layer 54, over the substrate surface 52. Electrode 56 provides the gate of the preferred field effect device. Electrode 56 typically comprises polysilicon and is defined by well known photolithographic and associated processing techniques.

FIG. 5 illustrates a stage of forming a device made in accordance with a preferred method just after doped regions are formed in the substrate. Specifically, first doped regions 60 and 62 are formed in the semiconductor substrate 50. The regions 60 and 62 are preferably formed with ion implantation of phosphorous at an implant angle of less than 10°, and preferably 0°. Implantation techniques are well known, and may be carried out with a dose of 3.0e13-6.0e13 atoms per cm² at an energy of 45 to 70 keV. Regions 60 and 62 provide the graded channel portions of the field effect device. Graded channel regions 60 and 62, in combination with phosphorous doped well 58 described above, provide the channel of the field effect device. The preferred embodiment includes graded channel regions at each side of the channel. However, other embodiments may have only one graded channel region at one side or the other of the channel.

Graded channel regions 60 and 62 are formed adjacent gate electrode 56. Graded channel regions 60 and 62 are consequently aligned by the edges of gate electrode 56, as is well understood in the art. A drive operation is performed after graded channel regions 60 and 62 are formed. The drive operation serves to move graded channel regions 60 and 62 further beneath the gate electrode 56, and to activate the regions. Preferably, the drive is accomplished with a furnace anneal of approximately thirty minutes at approximately 900-1,000°C.

FIG. 6 illustrates a stage in the formation of the device made by a method in accordance with the present invention wherein the layers necessary to provide sidewall spacers are formed. Specifically, a layer of approximately 300Å of deposited oxide, layer 70, is formed over the structure. Preferably the layer 70 comprises 300Å of TEOS SiO₂. Additionally, a layer of approximately 500-2,000Å of deposited nitride (Si₃N₄), layer 72, is formed over the structure. Layers 70 and 72 provide the material which composes sidewall spacers used in the preferred method.

FIG. 7 illustrates a stage in the formation of the device made by a method in accordance with the present invention, after sidewall spacers have been formed and after source/drain regions have been implanted, aligned by the spacers. Specifically, regarding the transition between the stage shown in FIG. 6 and the stage shown in FIG. 7, an anisotropic reactive ion etch (RIE) is used to define sidewall spacers 80 and 82, adjacent gate electrode 56. Subsequently, second doped regions 84 and 86 are formed adjacent the sidewalls, aligned by the sidewalls. Regions 84 and 86 are formed by implanting boron with well known implantation techniques. Regions 84 and 86 provide source/drain regions for the preferred field effect device.

The preferred embodiment employs defined spacers 80 and 82 for aligning the source/drain regions. Nevertheless, it will be understood that there are other mechanisms for impeding implantation near the vertical edge of electrode 56. The term "spacer" used here is intended to encompass all such mechanisms.

As is well known, the boron is p-type, providing holes as carriers. Of course, the dopant type of source/drain regions 84 and 86 is opposite that of graded channel regions 60 and 62 and channel well region 58.

According to the preferred method, regions 84, 86 are aligned by spacers 80 and 82. Preferably, regions 84 and 86 are formed within graded channel regions 60 and 62, respectively. Regions 84 and 86 are activated with a rapid thermal anneal (RTA) of approximately 45 seconds at approximately 1,065°C. The RTA process insures that source/drain regions 84 and 86 are not driven significantly further under gate electrode 56.

Regions 84 and 86 do extend somewhat laterally under gate electrode 56. The extent of regions 84 and 86 are indicated at 88 and 90, respectively.

Regions 84 and 86 have a particular carrier concentration profile which depends on the dopant implantation parameters and subsequent thermal cycle parameters used during their formation. In the preferred embodiment, the carrier concentration throughout regions 84 and 86 remain substantially constant, except very near the extent of the regions, where the concentration of course falls off. However, it will be understood that the carrier concentrations may vary. In any case, the respective extents, 88 and 90 of regions 84 and 86 meet and directly interface graded channel regions 60 and 62, respectively.
The lateral location of the interface is directly related to the thickness of sidewall spacers 80 and 82. Sidewall spacers 80 and 82 therefore serve to accurately locate the interface of the oppositely doped regions 84 and 86 within regions 60 and 62, respectively. Referring back to FIG. 3 in comparison to FIG. 2, the result of the preferred method of the present invention can be appreciated. Specifically, carrier concentration profile curve 40 of the source/drain region is pushed back to a relatively flat area of carrier concentration profile curve 42 of the graded channel region.

By now it should be appreciated that there has been provided a novel and non-obvious method for controlling carrier concentration at the interface of oppositely doped regions of a semiconductor device. According to a preferred method, providing spacers to offset the extent of one region accurately locates that region at the desired point of the carrier concentration profile of the second region. Thus, with the preferred method, the present invention provides substantial control over Vₜₕ for DMOS field effect devices.

## Claims

1. A method for controlling carrier concentration at the interface of oppositely doped regions of a semiconductor device, comprising the steps of:
providing a semiconductor substrate (50) doped with a first dopant type beneath a surface (52) of the semiconductor substrate (50);
forming an electrode (56) over the surface (52) of the semiconductor substrate (50);
forming a first doped region (60) of the first dopant type in the semiconductor substrate (50), the first doped region (60) being aligned by an edge of the electrode (56), the first doped region (60) having a first carrier concentration profile (42) having a flat portion and a steeply sloped portion;
forming a spacer (80) adjacent the electrode (56); and
forming a second doped region (84) of a second dopant type opposite the first dopant type in the first doped region (60), the second doped region (84) being aligned by the spacer (80), the second doped region (84) having an extent (88) in the lateral direction under the electrode, the extent (88) being determined by the spacer (80), the second doped region (84) meeting the first doped region (60) at the second doped region extent (88) at a location corresponding to the flat portion of the first carrier concentration profile (42).

2. The method of claim 1, wherein the step of forming the electrode (56) comprises forming a gate of a field effect device.

3. The method of claim 2, further comprising the step of forming an insulating layer (54) positioned between the gate (56) and the semiconductor substrate (50).

4. The method of claim 1, wherein the step of forming the spacer (80) comprises forming a sidewall (80).

5. The method of claim 1, wherein the step of forming the second doped region (84) comprises providing a second carrier concentration profile (40), wherein the second carrier concentration profile is substantially constant but falls off sharply at the second doped region extent (88).

6. A method for controlling carrier concentration at the interface of oppositely doped regions of a semiconductor device comprising the steps of:
providing a semiconductor substrate (50) doped with a first dopant type beneath a surface (52) of the semiconductor substrate;
forming an electrode (56) on the surface of the semiconductor substrate (52);
forming a graded doped region (60) having a first carrier type in the substrate adjacent an edge of the electrode (56);
driving the graded doped region beneath the electrode to provide a first carrier concentration profile (42) having a flat portion and a steeply sloped portion;
forming a spacer (80) adjacent the electrode (56); and
forming a second doped region (84) within the graded doped region (60), the second doped region (84) being aligned by the spacer (80) and having a second carrier type opposite the first carrier type, the second doped region (84) having an extent (88) in the lateral direction under the electrode (56), the extent (88) being determined by the spacer (80), the second doped region (84) meeting the graded doped region (60) at the second doped region extent (88) at a location within the flat portion of the first carrier concentration profile (42).

7. The method of claim 6, wherein the step of forming the graded doped region (60) comprises implanting dopants at an implant angle of less than 10°.

8. The method of claim 6, wherein the step of forming the spacer (80) comprises forming a nitride sidewall (80).

9. The method of claim 6, wherein the step of forming the second doped region (84) comprises providing a carrier concentration profile (40), the carrier concentration profile being substantially constant but falling off sharply at the second doped region extent (88).

10. The method of claim 6, wherein the step of forming the second doped region (84) comprises activating the second doped region with a rapid thermal anneal.
